# EUROPÄISCHE PATENTSCHRIFT

(11) **EP 0 651 512 B1**
(45) Veröffentlichungstag und Bekanntmachung des Hinweises auf die Patenterteilung: **24.06.1998**
(21) Anmeldenummer: 94117260.3
(22) Anmeldetag: 02.11.1994
(51) Int. Cl.: H03K 19/086, H03K 3/03, H03K 19/082, H03K 19/013

(54) **Ringoszillator**
Ring oscillator
Oscillateur en anneau

(30) Priorität: 03.11.1993 DE 4337511
(43) Veröffentlichungstag der Anmeldung: 03.05.1995
(73) Patentinhaber: SIEMENS AKTIENGESELLSCHAFT, 80333 München (DE)
(72) Erfinder: Wilhelm, Wilhelm, Dr.,Ing., D-81477 München (DE); Dirk, Friedrich, Ing., D-81739 München (DE)

(56) Entgegenhaltungen:
- EP-A- 0 430 653
- GB-A- 859 045
- JP-A-63 254 814
- US-A- 4 353 039
- US-A- 4 585 957
- US-A- 5 177 378
- IEEE TRANSACTIONS ON ELECTRON DEVICES, Bd. ed-32, Nr. 6, Juni 1985 NEW YORK US, Seiten 1086-1091, KURATA ET AL 'ring oscillator circuit simulation with physical model for gaas/gaaias heterojunction bipolar transistors'

## Beschreibung

Die Erfindung betrifft eine Inverterstufe gemäß dem Oberbegriff des Anspruchs 1.

Derartige Inverterstufen werden insbesondere bei einem "Voltage Controlled Oscillator" (VCO) verwendet. Derartige VCO's dienen zur Erzeugung eines Taktsignals, dessen Frequenz durch eine außen anlegbare Spannung eingestellt werden kann. Meist ist der VCO Element einer sogenannten PLL-Regelschleife (Phase Locked Loop).

Prinzipiell gibt es zwei Arten derartiger VCO's, nämlich RC-Oszillatoren, deren Frequenzänderung durch Hubänderung erfolgt oder Ringoszillatoren, deren Frequenzänderung durch Veränderung der Gatterlaufzeit erfolgt. Werden insbesondere hohe Frequenzen benötigt, so ist dies mit einem RC-Oszillator nur sehr schwer realisierbar. Ringoszillatoren erlauben zwar sehr hohe Frequenzen, jedoch ist der Frequenzbereich relativ eng.

Aus dem Stand der Technik GB 859 045 ist eine Schaltungsanordnung bekannt, die zur Ansteuerung von magnetischen Schreibköpfen für magnetische Speichermittel dient. Die Schaltung ist dazu geeignet, einen positiven oder negativen Strom zu erzeugen, der den logischen Zuständen +1 bzw. -1 entspricht.

Aus der US-Patentschrift US 4,585,957 ist eine Diodenlast-ECL-Schaltung mit zwei emittergekoppelten npn. Transistoren und einer steuerbaren Stromquelle bekannt. Der Lastkreis kann eine einzelne Diode oder zwei oder mehrere Dioden, die in Reihe geschaltet sind, umfassen.

Aus dem Stand der Technik JP-A 63 254 814 ist eine Feldeffekttransistor-Oszillator-Schaltung bekannt. Die dort beschriebene Schaltung ist so ausgelegt, daß Abweichungen im Schwellenwert bei der Herstellung eines Feldeffekttransistors unterdrückt werden können.

Aufgabe der vorliegenden Erfindung ist es einen Ringoszillator anzugeben, der die obengenannten Nachteile nicht aufweist.

Diese Aufgabe wird durch einen Ringoszillator gemäß Anspruch 1 gelöst. Bei bipolaren Gattern in ECL- oder CML-Technik läßt sich durch Änderung des Schaltstroms die Laufzeit nur unwesentlich verändern, da der die Laufzeit bestimmende Widerstand unverändert bleibt und der Signalhub sich mitverändert. Dies wird in vorteilhafterweise bei der erfindungsgemäßen Inverterstufe zur Verwendung in einem Ringoszillator vermieden. Der ansonsten übliche Lastwiderstand ist hier durch zwei in Reihe geschaltete Dioden ersetzt. Dadurch ist der die Laufzeit bestimmende Arbeitswiderstand vom Schaltstrom abhängig, wobei die Spannungsverstärkung und der Signalhub des Inverters unabhängig vom Schaltstrom bleibt. Bei der erfindungsgemäßen Anordnung einer Inverterstufe in einem Ringoszillator kann die Frequenz daher in weiten Grenzen variiert werden.

Die Erfindung wird nachfolgend anhand von vier Figuren näher erläutert. Es zeigen
Figur 1 eine symmetrische Inverterstufe,
Figur 2 eine unsymmetrische Inverterstufe,
Figur 3 ein Ringoszillator mit drei Inverterstufen gemäß Figur 1,
Figur 4 einen erfindungsgemäßen Ringoszillator mit drei Inverterstufen gemäß Figur 2.

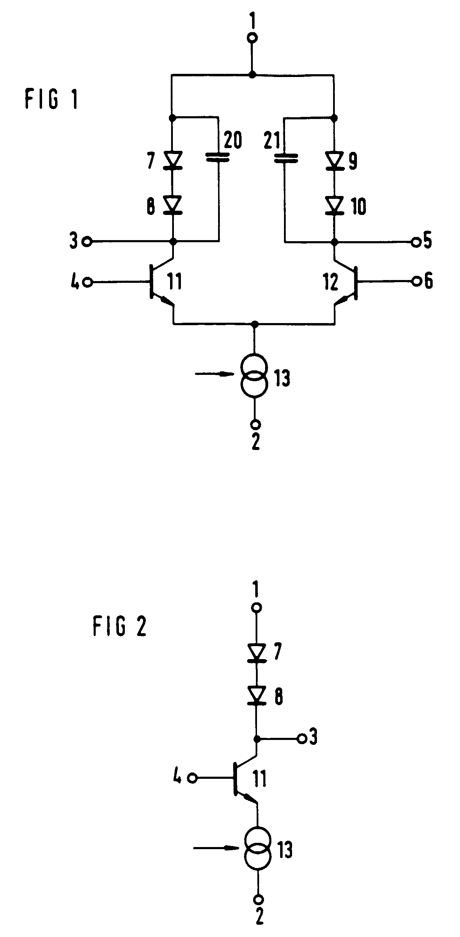

In Figur 1 mit 1 eine Versorgungsspannungsklemme bezeichnet, die mit der Anode einer Diode 7 und der Anode einer Diode 9 verbunden ist. Desweiteren ist die Versorgungsspannungsklemme 1 jeweils mit dem ersten Anschluß einer Kapazität 20 und einer Kapazität 21 verschaltet. Die Katode der ersten Diode 7 ist mit der Anode einer weiteren Diode 8 verbunden. Die Katode der Diode 8 ist mit dem zweiten Anschluß der Kapazität 20 und einer Ausgangsklemme 3 verschaltet. Desweiteren ist sie mit dem Kollektor eines npn-Transistors 11 verschaltet. Der Emitter des Transistors 11 ist über eine steuerbare Stromquelle 13 mit einer Bezugspotentialklemme 2 verschaltet. Die Basis des Transistors 11 ist mit einer Eingangsklemme 4 verbunden. Die Katode der Diode 9 ist mit der Anode einer weiteren Diode 10 verschaltet. Die Katode der Diode 10 ist mit dem zweiten Anschluß der Kapazität 21, einer Ausgangsklemme 5 und dem Kollektoranschluß eines weiteren npn-Transistors 12 verbunden. Der Basisanschluß des Transistors 12 ist mit einer Eingangsklemme 6 verschaltet. Der Emitteranschluß des Transistors 12 ist mit dem Emitteranschluß des Transistors 11 verbunden.

Figur 2 zeigt eine unsymmetrische Inverterstufe gemäß Figur 1. Gleiche Bauelemente sind mit gleichen Bezugszeichen versehen. Die Schaltung gemäß Figur 2 unterscheidet sich von der gemäß Figur 2 nur darin, daß der Zweig bestehend aus den Dioden 9, 10, der Kapazität 21 sowie dem Transistor 12 entfällt. Ebenso ist in Figur 2 auf die Kapazität 20 verzichtet worden.

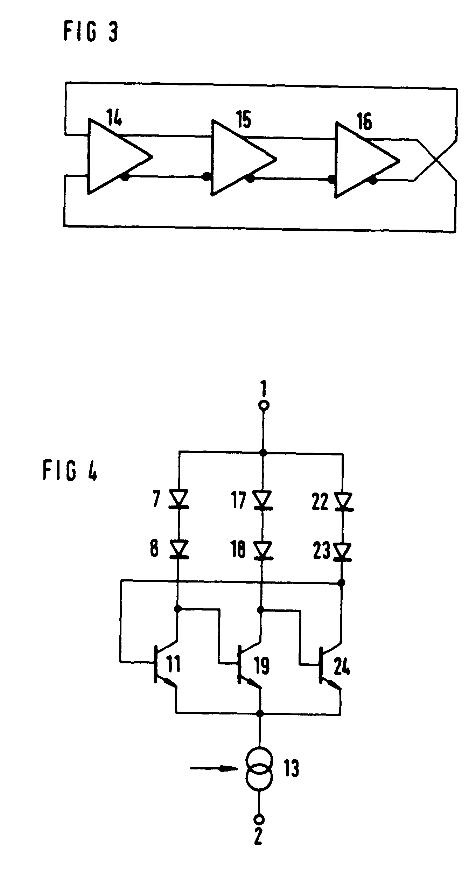

Der in Figur 3 dargestellte Ringoszillator besteht aus drei symmetrischen Inverterstufen gemäß Figur 1. Die Ausgänge der ersten Inverterstufe 14 sind mit den Eingängen der zweiten Inverterstufe 15 verschaltet. Die Ausgänge der Inverterstufe 15 sind mit den Eingängen der Inverterstufe 16 verschaltet. Schließlich sind die Ausgänge der Inverterstufe 16 über Kreuz mit den Eingängen der Inverterstufe 14 verbunden.

Der in Figur 4 dargestellte Ringoszillator besteht ebenfalls aus drei in Reihe geschalteten Inverterstufen. Jede Inverterstufe ist gemäß Figur 2 ausgebildet. Die erste besteht aus den Dioden 7, 8 und dem Transistor 11, die zweite aus den Dioden 17, 18 und dem Transistor 19 und die dritte aus den Dioden 22, 23 und dem Transistor 24. Die Emitter der Transistoren 11, 19 und 24 sind miteinander verbunden und über die steuerbare Stromquelle 13 mit der Bezugspotentialklemme 2 verbunden. Ebenso sind die Anoden der Dioden 7, 17 und 22 miteinander und mit der Versorgungsspannungsklemme 1 verschaltet. Der Ausgang des Transistors 11, d.h. der Abgriff zwischen Diode 8 und Kollektor des Transistors 11, ist mit der Basis des Transistors 19 verschaltet. Der Ausgang der zweiten Stufe, d.h. der Abgriff zwischen Dioden 18 und dem Kollektor des Transistors 19, ist mit der Basis des Transistors 24 verbunden. Schließlich ist der Ausgang der dritten Stufe, d.h. der Abgriff zwischen Diode 23 und dem Kollektor des Transistors 24, mit der Basis des Transistors 11 verschaltet.

Die in den Figuren dargestellten Ringoszillatoren ermöglichen Frequenzen bis im Gigaherzbereich und, wie zuvor dargestellt, kann die Frequenz in weiten Grenzen variiert werden. Schließlich konnte festgestellt werden, daß ab einer Inverteranzahl von 3 der Oszillator selbständig anschwingt. Selbstverständlich ist eine beliebige Anzahl von in Reihe geschalteten Invertern zur Realisierung eines Ringoszillators möglich. Die den Lastwiderstand ersetzende Reihenschaltung aus zwei Dioden kann auch um weitere Dioden erweitert werden. Parallel zu der Reihenschaltung der Dioden kann eine Kapazität geschaltet werden.

## Patentansprüche

1. Ringoszillator mit einer Anzahl von mindestens 3 in Reihe geschalteten Inverterstufen, wobei der Ausgang der letzten Inverterstufe mit dem Eingang der ersten Inverterstufe verbunden ist,
**dadurch gekennzeichnet,**
daß jede Inverterstufe einen npn-Transistor (11; 19; 24) aufweist, dessen Basisanschluß den Eingang der Inverterstufe bildet, dessen Kollektoranschluß den Ausgang der Inverterstufe bildet,
daß zwischen einer Versorgungsspannungsklemme (1) und dem Kollektoranschluß in jeder Inverterstufe eine Reihenschaltung aus wenigstens zwei Dioden (7, 8; 17, 18; 22, 23) vorgesehen ist, und
daß die Emitter aller npn-Transistoren miteinander verbunden sind und über eine steuerbare Stromquelle (13) mit einem Bezugspotential verbunden sind.

## Claims

1. Ring oscillator having a number of at least 3 series-connected invertor stages, the output of the last invertor stage being connected to the input of the first invertor stage,
characterized
in that each invertor stage has an npn transistor (11; 19; 24), whose base terminal forms the input of the invertor stage, and whose collector terminal forms the output of the invertor stage,
in that a series circuit formed by at least two diodes (7, 8; 17, 18; 22, 23) is provided between a supply voltage terminal (1) and the collector terminal in each invertor stage, and
in that the emitters of all the npn transistors are connected to one another and are connected via a controllable current source (13) to a reference-earth potential.

## Revendications

1. Oscillateur en anneau comprenant au moins trois inverseurs montés en série, la sortie du dernier inverseur étant reliée avec l'entrée du premier inverseur, caractérisé en ce que chaque inverseur comporte un transistor NPN (11 ; 19 ; 24) dont la borne de base forme l'entrée de l'inverseur et dont la borne de collecteur forme la sortie de l'inverseur, en ce qu'entre une borne de tension d'alimentation (1) et la borne de collecteur, dans chaque inverseur, est prévu un montage en série comprenant au moins deux diodes (7, 8 ; 17, 18 ; 22, 23) et en ce que les émetteurs de tous les transistors NPN sont reliés entre eux et, par l'intermédiaire d'une source de courant (13) commandée, avec un potentiel de référence.
